# EUROPEAN PATENT APPLICATION

(11) **EP 4 611 031 A1**
(43) Date of publication of application: **03.09.2025**
(21) Application number: 24160444.6
(22) Date of filing: 29.02.2024
(51) Int. Cl.: H01L 21/768, H01L 21/822, H01L 21/8238, H01L 27/06

(54) **A METHOD FOR FORMING A SEMICONDUCTOR DEVICE, AND A SEMICONDUCTOR DEVICE**

(71) Applicant: Imec VZW, 3001 Leuven (BE)
(72) Inventor: MERTENS, Hans, 3000 Leuven (BE); HELLINGS, Geert, 1500 Halle (BE); BOEMMELS, Juergen, 3001 Heverlee (BE); GUPTA, Anshul, 3001 Leuven (BE)
(74) Representative: AWA Sweden AB

(57) **Abstract**

A method (100) for forming a semiconductor device (1), the method comprising:
forming a stack of field effect transistors (60), FETs, on top of a substrate (4), the stack of FETs comprising a bottom FET (61) and a top FET (62), the bottom FET (61) comprising at least a first source/drain region (51);
forming a first insulating layer (11) laterally surrounding the stack of FETs (60);
etching a hole (20) into the first insulating layer (11), the hole (20) extending between a top endpoint (26) and a bottom endpoint (25);
filling the hole (20) with electrically conductive material such that the electrically conductive material of the filled hole (20) forms a via (21);
etching, from a bottom side (4b) of the substrate (4) towards the first insulating layer (11), a trench (30), such that a top part (30p) of the trench (30) comprises both a bottom side (51b) of the first source/drain region (51) and the bottom endpoint (25);
filling the top part (30p) of the trench (30) with electrically conductive material, such that the electrically conductive material of the filled top part (30p) of the trench (30) electrically connects the bottom side (51b) of the first source/drain region (51) to the bottom endpoint (25) of the via (21).

## Description

### TECHNICAL FIELD

The present disclosure relates to a semiconductor device and a method for forming the semiconductor device.

### BACKGROUND

To enable more area- and power-efficient circuits, vertical semiconductor device structures are receiving increasing attention as an alternative to traditional planar semiconductor devices. One notable example is stacked transistor devices comprising a complementary pair of field effect transistors (FETs) stacked on top of each other, i.e. a p-type FET (pFET) on top of a n-type FET (nFET) or vice versa. A complementary pair of FETs stacked on top of each other is called a complementary FET (CFET).

### SUMMARY

It is an objective of the present inventive concept to enable a compact semiconductor device. In particular, it is an objective to enable a compact CFET.

It is a further objective of the present inventive concept to facilitate easy and/or low cost manufacturing of the semiconductor device. In particular, it is an objective to facilitate relaxed constrains for the thermal budget during manufacturing and/or relaxed constrains for contamination.

It is a further objective of the present inventive concept to enable a high quality semiconductor device. In particular, it is an objective to reduce thermal damage to metal contacts and dielectric layers. Further, it is an objective to reduce metal contamination.

These and other objectives of the inventive concept are at least partly met by the invention as defined in the independent claims. Preferred embodiments are set out in the dependent claims.

According to a first aspect, there is provided a method for forming a semiconductor device, the method comprising:
forming a stack of field effect transistors, FETs, on top of a substrate, the stack of FETs comprising a bottom FET and a top FET, the top FET being stacked on top of the bottom FET, the bottom FET comprising at least a first source/drain region;
forming a first insulating layer, the first insulating layer laterally surrounding the stack of FETs;
etching a hole into the first insulating layer, the hole being laterally spaced apart from the stack of FETs, the hole extending between a top endpoint and a bottom endpoint, the top endpoint being arranged at a top side of the first insulating layer, the bottom endpoint being arranged at a level below a bottom level of the top FET;
filling the hole with electrically conductive material such that the electrically conductive material of the filled hole forms a via;
etching, from a bottom side of the substrate towards the first insulating layer, a trench, such that a top part of the trench comprises both a bottom side of the first source/drain region and the bottom endpoint; and
filling the top part of the trench with electrically conductive material, such that the electrically conductive material of the filled top part of the trench electrically connects the bottom side of the first source/drain region to the bottom endpoint of the via, whereby the filled top part of the trench forms an interconnect.

Relative spatial terms such as "top", "bottom", "lower", "vertical", "stacked on top of", are herein to be understood as denoting locations or directions within a frame of reference of the semiconductor device. In particular, the terms may be understood in relation to a normal direction to the substrate on which the device layer stack is formed, or equivalently in relation to a bottom-up direction of the device layer stack. Correspondingly, terms such as "lateral" and "horizontal" are to be understood as locations or directions parallel to the substrate.

The bottom FET may be a pFET and the top FET may be a nFET, or vice versa. Thus, the stack of FETs may be a CFET. Alternatively, both the bottom FET and the top FET may be pFETs. Alternatively, both the bottom FET and the top FET may be nFETs.

Each of the bottom FET and the top FET may comprise at least one channel layer for charge transport. The channel layers may be part of a stack of layers forming a fin. The fin may comprise two opposing lateral side faces, two opposing lateral end faces, and a top face. A bottom face of the fin may be facing the substrate. Each channel layer may comprise a semiconductor, e.g. silicon. The substrate may comprise a semiconductor. The substrate may be e.g. a silicon substrate or a silicon-on-insulator substrate.

Each of the bottom FET and the top FET may comprise two source/drain regions, being arranged at opposite ends of the at least one channel layer, i.e. at the opposing lateral end faces of the fin. Thus, the first source/drain region may be a source/drain region at one of the ends of the channel layer of the bottom FET. Each source/drain region may comprise a semiconductor, e.g. silicon. Each source/drain region may be doped, e.g. p doped when belonging to a pFET or n doped when belonging to a nFET.

Each of the bottom FET and the top FET may comprise a gate configured to control the charge transport through the at least one channel layer. The gate may be e.g. a gate-all-around extending around the channel layers or a tri-gate at three sides of the channel layers.

The first insulating layer may be called zero-level interlayer dielectric (ILD0). The first insulating layer may comprise electrically insulating material, e.g. dielectric material. The first insulating layer may comprise SiO₂ and/or SiOC. The first insulating layer may be formed by e.g. Plasma-Enhanced Chemical Vapor Deposition (PECVD) or Low-Pressure Chemical Vapor Deposition (LPCVD).

The via and the interconnect may form an electrical connection from the first source/drain region to the top side of the first insulating layer. Thus, the interconnect is an electrical connection from the first source/drain region to the via and the via is an electrical connection from the interconnect to the top side of the first insulating layer.

The inventors have realized that the interconnect between the first source/drain region and the via is advantageous as it facilitates a compact semiconductor device. The interconnect may extend laterally from the first source/drain region to the via. Thus, the interconnect and the via may form a short and/or compact signal line to the top side of the first insulating layer. Thus, there may be no need to rout the signal line to a backside power delivery network and then to dedicated vias between said backside power delivery network and the top side of the first insulating layer. Such routing through a backside power delivery network may be associated with an area penalty.

The inventors have realized that it is advantageous to etch the trench from the bottom side of the substrate, i.e. by backside etching. Thus, at least part of the process of forming the interconnect is performed from the bottom side of the substrate. For example, filling the top part of the trench with electrically conductive material may be performed from the bottom side of the substrate.

Bottom side processing (i.e. backside processing) facilitates relaxed constrains for the thermal budget during manufacturing. As an example, lateral interconnects grown epitaxially may not be needed. Thus, the stack of FETs may not need to be subjected to the heat associated with such growth. In other words, the stack of FETs may not need to be heated unnecessarily, which may reduce heat damage to metal contacts and dielectric layers.

Bottom side processing (i.e. back side processing) facilitates relaxed constrains for contamination. For example, metal contacts and/or metal interconnects may be formed after epitaxial growth, e.g. after epitaxial growth of source/drain regions. Thus, it is possible to avoid metal going into the epitaxy machine. Such metal may contaminate the epitaxy machine and affect the growth run in question or future growth runs.

As mentioned, the trench is etched from the bottom side of the substrate, this may be called backside trench-etching.

The hole may be etched from the top side of the first insulating layer, this may be called frontside hole-etching.

Alternatively, the hole may be etched from the bottom side of the substrate, this may be called backside hole-etching.

Frontside and backside hole-etching will be discussed further below.

Etching may be performed by dry etching, e.g. by plasma etching. Alternatively or additionally, etching may be performed by wet etching.

Etching from the bottom side of the substrate may be construed as the bottom side of the substrate facing the etchant and/or being exposed to the etchant, e.g. the bottom side of the substrate facing a plasma etchant. Analogously, etching from the top side of the first insulating layer may be construed as the top side of the first insulating layer facing the etchant and/or being exposed to the etchant, e.g. the top side of the first insulating layer facing a plasma etchant.

As mentioned, the hole is etched into the first insulating layer, laterally spaced apart from the stack of FETs. Thus, the hole may be laterally spaced apart from source/drain regions of the stack of FETs, e.g. by at least 5 nm, or at least 10 nm. Thus, the hole may be laterally spaced apart from the channel layers of the stack of FETs. Thus, the hole may be laterally spaced apart from the gates of the stack of FETs.

Etching the trench from the bottom side of the substrate may be performed after thinning at least parts of the substrate from the bottom side.

A position of an etched hole or trench may be defined by patterning, e.g. lithographic patterning.

It should be understood that one or more etch stop layers may be used to stop the etch at desired levels.

Filling may be performed by deposition, e.g. Chemical Vapor Deposition (CVD), Physical Vapor Deposition (PVD), or Atomic Layer Deposition (ALD). The electrically conductive material filling the hole may be e.g. tungsten (W), molybdenum (Mo), ruthenium (Ru), cobalt (Co), with or without an adhesion liner, e.g., titanium nitride (TiN). The electrically conductive material filling the top part of the trench may be e.g. tungsten (W), molybdenum (Mo), ruthenium (Ru), cobalt (Co), with or without an adhesion liner, e.g., titanium nitride (TiN). In particular, the electrically conductive material filling the hole and/or filling the top part of the trench may be a metal.

Filling from the bottom side of the substrate may be construed as the bottom side of the substrate facing the deposition source, e.g. the bottom side of the substrate facing a CVD source, a PVD source or an ALD source. Analogously, filling from the top side of the first insulating layer may be construed as the top side of the first insulating layer facing the deposition source.

The top part of the trench may comprise also at least part of a lateral side of the first source/drain region, such that the electrically conductive material of the filled top part of the trench electrically connects also the lateral side of the first source/drain region to the via.

Thus, the trench may be etched past the bottom side of the first source/drain region, thereby exposing the bottom side of the first source/drain region as well as part of a lateral side of the first source/drain region. Thus, the bottom side of the first source/drain region as well as part of a lateral side of the first source/drain region may be electrically connected by the electrically conductive material filling the top part of the trench.

When the electrically conductive material of the filled top part of the trench electrically connects both the bottom side of the first source/drain region and the lateral side of the first source/drain region to the via, the resistance of the interconnect may be small. For example, a large contact area between the electrically conductive material of the filled top part of the trench and the first source/drain region may be achieved when the electrically conductive material of the filled top part connects both the bottom side of the first source/drain region and the lateral side of the first source/drain region to the via. Thus, a contact resistance may be small.

It is a realization that the method enables a small vertical distance between the bottom FET and the top FET. A vertical distance between the bottom FET and the top FET may be smaller than 50 nm. In other words, a vertical distance between the uppermost channel layer of the bottom FET and the lowermost channel layer of the top FET may be smaller than 50 nm. In contrast, an interconnect formed by front side processing may need a larger vertical distance between the bottom FET and the top FET to avoid a short circuit between the bottom FET and the top FET. Depending on the precision needed, other values for the vertical distance may be foreseen. A vertical distance between the bottom FET and the top FET may be smaller than 70 nm. A vertical distance between the bottom FET and the top FET may be smaller than 30 nm.

The method may further comprise:
forming a second insulating layer below the electrically conductive material of the filled top part of the trench;
forming a backside power delivery network below the second insulating layer, wherein the second insulating layer electrically insulates the backside power delivery network from the electrically conducive material of the filled top part of the trench.

The backside power delivery network may be used for routing of signals. Since the interconnect and the via may rout a signal from the first source/drain region to the top side of the first insulating layer without passing through the backside power delivery network, the space below the interconnect is free for routing of other signals (e.g. from other stacks of FETs) in the backside power delivery network. The second insulating layer may thus electrically insulate the interconnect from the backside power delivery network. The second insulating layer may comprise SiO₂ and/or SiOC. The second insulating layer may be formed by e.g. Plasma-Enhanced Chemical Vapor Deposition (PECVD) or Low-Pressure Chemical Vapor Deposition (LPCVD).

The electrically conductive material filling the top part of the trench may be a metal.

Thus, epitaxially grown lateral connections may be avoided. The metal filling the top part of the trench may be deposited from the bottom side of the substrate.

Forming the stack of FETs may comprise:
forming source/drain regions of the bottom and top FET by epitaxial growth;
wherein said acts of filling the hole with electrically conductive material and filling the top part of the trench with electrically conductive material are performed after said act of forming the source/drain regions of the bottom and top FET.

Thus, the electrically conductive material of the hole and the electrically conductive material of the top part of the trench may be prevented from contaminating the epitaxy machine.

The hole may be etched in various ways, sorted into two major categories which may be called frontside hole-etching and backside hole-etching, as mentioned above.

The act of etching the hole may comprise etching at least part of the hole from a top side of the first insulating layer. This may be seen as frontside hole-etching. Etching part of the hole from a top side of the first insulating layer is compatible with well-established methods for forming vias through an ILD0 layer. Further, patterning of the hole is easy from the frontside. Thus, frontside hole-etching may be easy and/or inexpensive to implement.

An etchstop, also called etch stop layer, may be used to stop the etch at a desired level. For example, frontside hole-etching may be performed with an etchstop. For example, the first insulating layer may comprise a first sublayer, a second sublayer stacked on top of the first sublayer, and a third sublayer stacked on top of the second sublayer, the second sublayer being arranged between the bottom and top FETs, the second and third sublayers comprising different insulating materials;
forming the hole may then comprise:
selectively etching a first part of the hole through the third sublayer down to the second sublayer;
forming a second part of the hole by expanding the first part of the hole through the second sublayer.

Etching the first part of the hole may be performed by a first etch. The first etch may be configured to have a high etch rate for the third sublayer and a low etch rate for the second sublayer. The etch rate for the third sublayer and the second sublayer may differ by at least a factor 10.

Thus, the first etch may stop or slow down substantially when reaching the second sublayer. In other words, it is possible to ensure that the etch has reached a level between the bottom and top FETs by etching for a long time while the second sublayer (acting as an etchstop) prevents the etch from going too far.

Forming a second part of the hole by expanding the first part of the hole through the second sublayer may then be performed using a second etch. Forming the second part of the hole may be called punch-through. The second etch may be different from the first etch. The second etch may e.g. be non-selective. The second etch may have a higher etch rate for the material of the second sublayer than the first etch.

The hole may be filled with electrically conductive material from the top side of the first insulating layer, this may be called frontside hole-filling. Alternatively, the hole may be filled with electrically conductive material from the bottom side of the substrate, after forming the trench, this may be called backside hole-filling.

Frontside hole-filling may be easy and/or inexpensive to implement.

Backside hole-filling makes it possible to perform both two acts of filling the hole with electrically conductive material and filling the top part of the trench with electrically conductive material, from the bottom side of the substrate. Thus, the hole and the top part of the trench may be filled with electrically conductive material during one single pass through the deposition machine. There may be no need to first fill the hole from the top side of the first insulating layer, in a first pass through the deposition machine; then take the semiconductor device out of the deposition machine; and later fill the top part of the trench from the bottom side of the substrate in a second pass through the deposition machine. Further, good electrical contact between the interconnect and the via may be achieved.

Backside hole-filling may be implemented together with frontside hole-etching, e.g. by the use of sacrificial material. For example, frontside hole-etching may be followed by deposition of sacrificial material. For example, the method may comprise:
depositing a sacrificial material in the hole before etching the trench;
removing the sacrificial material in the hole after etching the trench, by etching, from the bottom side of the substrate, the sacrificial material;
wherein said act of filling the hole with electrically conductive material is performed by filling, from the bottom side of the substrate, the hole with electrically conductive material after said act of removing the sacrificial material.

Thus, the hole may be etched from the top side of the first insulating layer. The sacrificial material may then be deposited in the hole. The sacrificial material may be e.g. silicion oxide (SiO), amorphous silicon (a-Si), or amorphous silicon-germanium (a-SiGe). The trench may subsequently be etched from the bottom side of the substrate until the top part of the trench reaches the bottom endpoint of the sacrificial material. The sacrificial material may then be etched from the bottom side of the substrate until removed. Electrically conductive material may then be deposited, e.g. simultaneously or sequentially, from the bottom side of the substrate, into both the hole and the trench. As understood from the above, the act of filling the top part of the trench with electrically conductive material may be performed from the bottom side of the substrate after said act of filling the hole with electrically conductive material.

Backside hole-filling may be implemented together with backside hole-etching. For example, the act of etching the hole may be performed after the act of etching the trench and the method may further comprise:
etching the hole from the bottom side of the substrate;
wherein the act of filling the hole with electrically conductive material is performed from the bottom side of the substrate.

According to a second aspect, there is provided a semiconductor device. A device according to the second aspect may have the same advantages, or similar advantages, as the advantages described in conjunction with the method according to the first aspect.

According to the second aspect, there is provided a semiconductor device comprising:
a stack of field effect transistors, FETs, arranged on top of a substrate, the stack of FETs comprising a bottom FET and a top FET, the top FET being stacked on top of the bottom FET, the bottom FET comprising at least a first source/drain region;
a first insulating layer, the first insulating layer laterally surrounding the stack of FETs;
a via comprising a hole filled with electrically conductive material, the hole being laterally spaced apart from the stack of FETs, the hole extending between a top endpoint and a bottom endpoint, the top endpoint being arranged at a top side of the first insulating layer, the bottom endpoint being arranged at a level below a bottom level of the top FET;
an interconnect comprising a top part of a trench filled with electrically conductive material, the trench extending from a bottom side of the substrate towards the first insulating layer, wherein the top part of the trench comprises both a bottom side of the first source/drain region and the bottom endpoint of the via, the electrically conductive material of the filled top part of the trench electrically connecting the bottom side of the first source/drain region to the bottom endpoint of the via.

The semiconductor device may be configured such that the top part of the trench comprises also at least part of a lateral side of the first source/drain region, such that the electrically conductive material of the filled top part of the trench electrically connects also the lateral side of the first source/drain region to the via.

The semiconductor device may be configured such that a vertical distance between the bottom FET and the top FET is smaller than 50 nm.

The semiconductor device may further comprise:
a second insulating layer below the electrically conductive material of the filled top part of the trench;
a backside power delivery network below the second insulating layer, wherein the second insulating layer electrically insulates the backside power delivery network from the electrically conductive material of the filled top part of the trench.
The semiconductor device may be configured such that the electrically conductive material filling the top part of the trench is a metal.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 illustrates a cross-sectional view of a semiconductor device
Fig. 2 illustrates a method for forming a semiconductor device
Fig. 3 illustrates a method for forming a semiconductor device
Fig. 4 illustrates a method for forming a semiconductor device
Fig. 5 illustrates a method for forming a semiconductor device

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

The figures illustrate the semiconductor device 1 and the method for forming the semiconductor device 1.

Axes X, Y and Z are indicated in all figures. Axes X, Y and Z indicate a first direction, a second direction transverse to the first direction, and a vertical or bottom-up direction, respectively. The X- and Y-direction may in particular be referred to as lateral or horizontal directions in that they are parallel to a main plane of a substrate 4 of the semiconductor device 1. The Z-direction is parallel to a normal direction to the substrate 4.

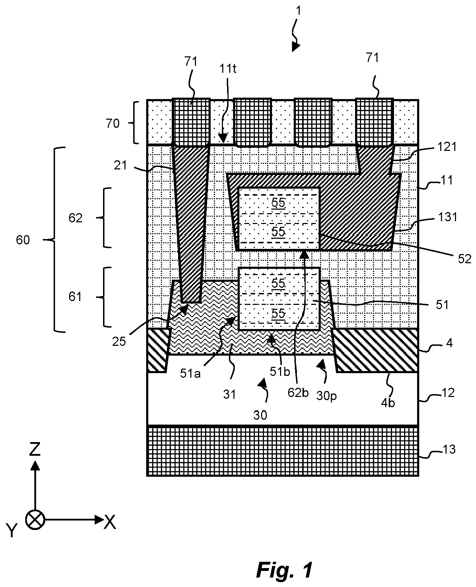

Fig. 1 illustrates a cross-sectional view of a semiconductor device 1 comprising a stack of FETs 60, arranged on top of a substrate 4. The stack of FETs 60 comprising a bottom FET 61 and a top FET 62, the top FET 62 being stacked on top of the bottom FET 61.

The bottom FET 61 may be a pFET and the top FET 62 may be a nFET, or vice versa. Thus, the stack of FETs 60 may be a CFET. Alternatively, both the bottom FET 61 and the top FET 62 may be pFETs. Alternatively, both the bottom FET and the top FET may be nFETs.

Each of the bottom FET 61 and the top FET 62 may comprise at least one channel layer 55 for charge transport. Each channel layer 55 may comprise a semiconductor, e.g. silicon. The channel layers 55 may be part of a stack of layers forming a fin. The bottom FET 61 may comprise a plurality of channel layers 55, e.g. at least two channel layers 55 or at least three channel layers 55. Similarly, the top FET 62 may comprise a plurality of channel layers 55, e.g. at least two channel layers 55 or at least three channel layers 55.

As illustrated, the bottom FET 61 comprises a first source/drain region 51. The first source/drain region 51 may be arranged on a lateral end face of the fin, in contact with the one or more channel layer 55 of the bottom FET 61. Said lateral end face of the fin may be orthogonal to the second direction, i.e. Y-direction. Fig. 1 illustrates a cross-sectional view through the first source/drain region 51 but, for clarity, the channel layers 55 of the bottom FET 61 behind the first source/drain region 51 are illustrated with dashed lines. The channel layers 55 of the bottom FET 61 may then extend in the second direction, i.e. Y-direction, to a source/drain region opposite to the first source/drain region 51. In other words, in the illustrated semiconductor device, current of the bottom FET 61 may flow in the in the second direction, i.e. Y-direction.

As illustrated, the top FET 62 comprises a second source/drain region 52. The second source/drain region 52 may be arranged on the same lateral end face of the fin as the first source/drain region 51. The top FET 62 may, analogously to the bottom FET 61 have one or more channel layer 55 extending in the second direction between the second source/drain region 52 and a source/drain region opposite to the second source/drain region 52. The channel layers 55 of the top FET 62, behind the second source/drain region 52, are illustrated with dashed lines.

Each source/drain 51, 52 region may comprise a semiconductor, e.g. silicon. Each source/drain region 51, 52 may be doped, e.g. p doped when belonging to a pFET or n doped when belonging to a nFET.

Each of the bottom FET 61 and the top FET 62 may comprise a gate (not shown) configured to control the charge transport through the at least one channel layer 55.

The semiconductor device 1 of Fig. 1 further comprises a first insulating layer 11, a via 21 and an interconnect 31. The via 21 and the interconnect comprise electrically conductive material, e.g. metal.

The first insulating layer 11 laterally surrounds the stack of FETs 60. The first insulating layer 11 may be an ILD0 layer. The first insulating layer 11 may comprise SiO₂ and/or SiOC.

The bottom FET 61 and the top FET 62 may be separated by electrically insulating material. For example, channel layers 55 of the bottom FET 61 may be separated from channel layers 55 of the top FET 62 by electrically insulating material. The first source/drain region 51 may be separated from the second source/drain region 52 by electrically insulating material. Electrically insulating material separating the bottom FET 61 and the top FET 62 may comprise parts of the first insulating layer 11.

A vertical distance between the bottom FET 61 and the top FET 62 may be smaller than 50 nm. In other words, a vertical distance between the uppermost channel layer 55 of the bottom FET 61 and the lowermost channel layer 55 of the top FET 62 may be smaller than 50 nm.

The via 21 is a hole 20 filled with electrically conductive material. The via 21 extends from a top endpoint 26, at a top side 11t of the first insulating layer 11, to a bottom endpoint 25 at a level below a bottom level 62b of the top FET 62. Thus, a vertical distance between the substrate 4 and the bottom endpoint 25 of the via 21 may be shorter than a vertical distance between the substrate 4 and the bottom level 62b of the top FET 62. The bottom level 62b of the top FET 62 may be a bottom level of the second source/drain region 52. The via 21 is laterally spaced apart from the stack of FETs 60. Thus, the via 21 may be laterally spaced apart from the second source/drain region 52.

The interconnect 31 comprises a top part 30p of a trench 30 filled with electrically conductive material, the trench 30 extending from a bottom side 4b of the substrate 4 towards the first insulating layer 11, wherein the top part 30p of the trench 30 comprises both the bottom side 51b of the first source/drain region 51 and the bottom endpoint 25 of the via 21.

The interconnect 31 extends, in the figure, laterally between the via 21 and the first source/drain region 51. Thus, the via 21 is electrically connected to the first source/drain region 51 by the interconnect 31. In the figure, the interconnect 31 extends laterally in the first direction, i.e. the X-direction. The interconnect 31 extends vertically in the third direction, i.e. the Z-direction, such that the interconnect 31 connects at least to the bottom side 51b of the first source/drain region 51. In the figure, the interconnect 31 connects additionally to part of a lateral side 51a of the first source/drain region 51. In the figure, the interconnect 31 connects to the lower part of a lateral side 51a of the first source/drain region 51.

The semiconductor device 1 may, as shown in Fig. 1, further comprise
a second insulating layer 12 below the electrically conductive material of the filled top part 30p of the trench 30; and
a backside power delivery network 13 below the second insulating layer, wherein the second insulating layer 12 electrically insulates the backside power delivery network 13 from the electrically conductive material of the filled top part 30p of the trench 30.

As seen in the figure, the second insulating layer 12 may fill the part of the trench 30 which is not filled with electrically conductive material.

It should be understood that the semiconductor device 1 may, alternatively, be implemented without a second insulating layer 12 and/or without a backside power delivery network 13.

The semiconductor device 1 may, as shown in Fig. 1, further comprise a MINT layer 70 comprising MINT lines 71 for electrically connecting the stack of transistors 60 to other electrical components, e.g. other stacks of transistors. The MINT layer 70 may be the first horizontal metal layer in the standard cell comprising the CFET. Accordingly, the MINT lines 71 may be metal lines. In Fig. 1, the first source/drain region 51 is connected to a MINT line 71 through the via 21 and the interconnect 31. Similarly in Fig. 1, the second source/drain region 52 is connected to another MINT line 71 through another via 121 and another interconnect 131.

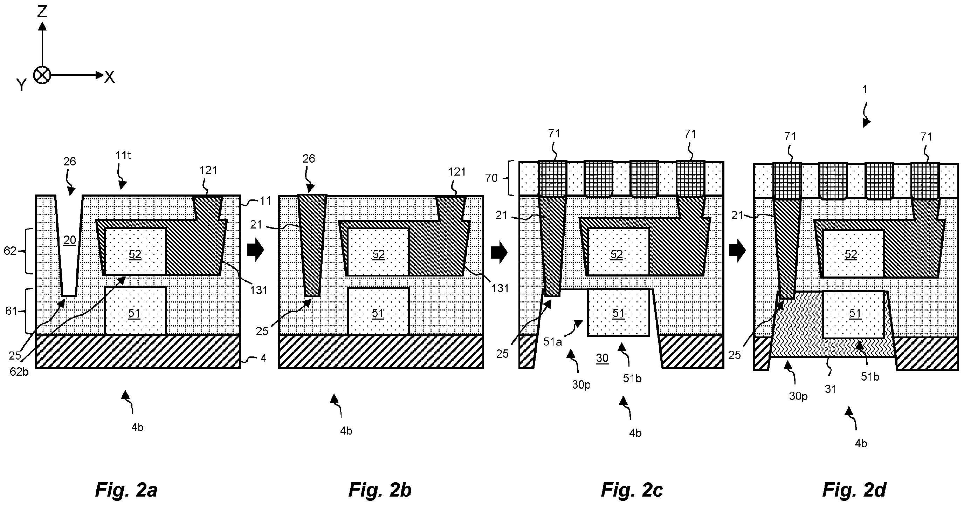

In the following, a method for forming a semiconductor device 1 is described in conjunction with Figs 2a-d to 5a-b. These figures show cross-sectional views of the semiconductor device 1, during production, corresponding to the cross-sectional view of Fig. 1.

Figs 2a-d to 5a-b all show formation of a semiconductor device 1 wherein the first source/drain region 51 and the second source/drain region 52 as well as connections to the second source/drain region 52, by via 121 and interconnect 131, are already in place. However, it should be understood that the method may comprise forming said features. In particular, the method may comprise:
forming source/drain regions 51, 52 of the bottom 61 and top 62 FET by epitaxial growth. Said epitaxial growth may be performed before filling the hole 20 with electrically conductive material and filling the top part 30p of the trench 30 with electrically conductive material.

Fig. 2a-d illustrates the formation of a semiconductor device 1 wherein hole-etching and hole-filling are performed from the frontside and trench-etching and trench-filling are performed from the backside. The steps of Fig. 2a-d may be performed in the order indicated by the arrows between the figures.

Fig. 2a illustrates the semiconductor device 1 after forming the stack of FETs 60, forming the first insulating layer 11, and etching a hole 20 into the first insulating layer 11. The hole 20 is laterally spaced apart from the stack of FETs 60, the hole 20 extends between a top endpoint 26 and a bottom endpoint 25, the top endpoint 26 being arranged at a top side 11t of the first insulating layer 11, the bottom endpoint 25 being arranged at a level below a bottom level 62b of the top FET 62. In the figure, the hole 20 is etched from the top side 11t of the first insulating layer 11, i.e. frontside hole-etching. A characteristic of a hole 20 etched by frontside-etching may be that it tapers downwards, i.e. the width of the hole 20 at the top endpoint 26 may be larger than the width of the hole 20 at the bottom endpoint 25.

Fig. 2b illustrates the semiconductor device 1 after filling the hole 20 with electrically conductive material such that the electrically conductive material of the filled hole 20 forms a via 21.

Fig. 2c illustrates the semiconductor device 1 after a trench 30 being etched, from a bottom side 4b of the substrate 4 towards the first insulating layer 11, such that a top part 30p of the trench 30 comprises both a bottom side 51b of the first source/drain region 51 and the bottom endpoint 25. In the figure, the trench has been etched past the bottom side 51b of the first source/drain region 51 such that the top part 30p of the trench 30 comprises also part of a lateral side 51a of the first source/drain region 51, in addition to the bottom side 51b of the first source/drain region 51.

In the figure, the trench 30 is etched from the bottom side 4b of the substrate 4 towards the first insulating layer 11, i.e. backside trench-etching. A characteristic of a trench 30 etched by backside-etching may be that it tapers upwards, i.e. the width of the bottom of the trench 30 may be larger than the width of the top of the trench 30.

Fig. 2c further illustrates that a MINT layer 70 may be formed on top of the first insulating layer 11 before etching the trench 30. For example a MINT line 71 may be formed on top of the via 21.

Fig. 2d illustrates the semiconductor device 1 after the top part 30p of the trench 30 being filled with electrically conductive material, such that the electrically conductive material of the filled top part 30p of the trench 30 electrically connects the bottom side 51b of the first source/drain region 51 to the bottom endpoint 25 of the via 21, whereby the filled top part 30p of the trench 30 forms an interconnect 31.

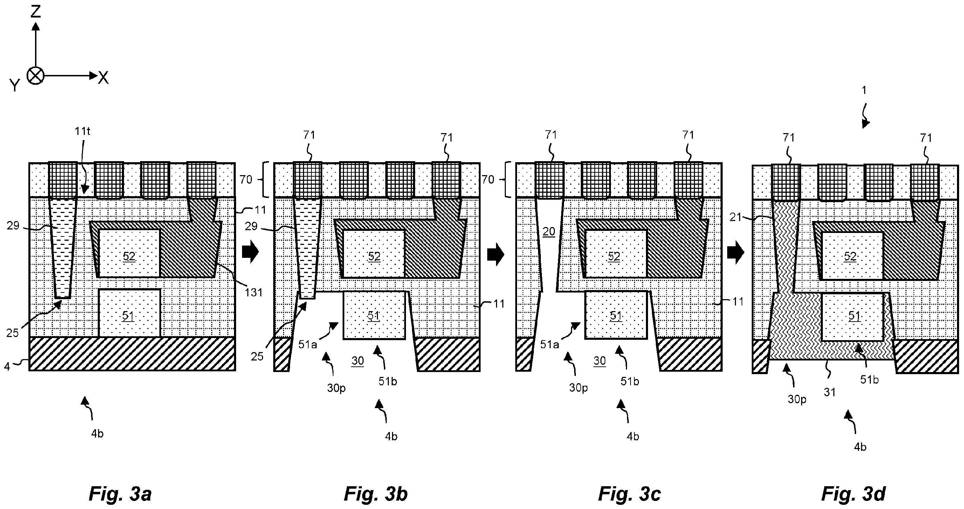

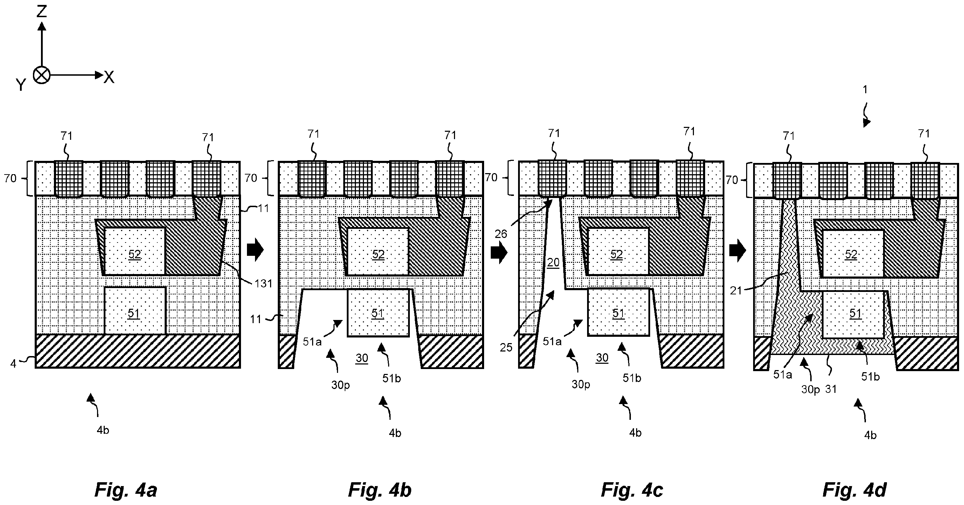

In the following, backside hole-filling will be discussed in conjunction with Figs 3a-d and Fig. 4a-d.

Fig. 3a-d illustrate that a hole 20 etched from the frontside may be filled using backside hole-filling, e.g. by use of a sacrificial material 29. The steps of Fig. 3a-d may be performed in the order indicated by the arrows between the figures.

Fig. 3a illustrates the semiconductor device 1 after forming the stack of FETs 60, forming the first insulating layer 11, etching a hole 20 into the first insulating layer 11, and depositing a sacrificial material 29 in the hole 20.

Fig. 3a further illustrate that a MINT layer 70 may be formed on top of the first insulating layer 11 before etching the trench 30. For example a MINT line 71 may be formed on top of the sacrificial material 29.

Fig. 3b illustrates the semiconductor device 1 after a trench 30 being etched, from the bottom side 4b of the substrate 4 towards the first insulating layer 11, such that the top part 30p of the trench 30 comprises both the bottom side 51b of the first source/drain region 51 and the bottom endpoint 25. The bottom endpoint 25 may herein be marked by the bottom end of the sacrificial material 29.

Fig. 3c illustrates the semiconductor device 1 after removing the sacrificial material 29 in the hole 20 from the bottom side 4b of the substrate 4. The sacrificial material 29 may be removed by etching, e.g. by selective etching.

Fig. 3d illustrates the semiconductor device 1 after filling the hole 20 with electrically conductive material and filling the top part 30p of the trench 30 with electrically conductive material. The hole 20 and the top part 30p of the trench 30 may be filled with electrically conductive material simultaneously, e.g. in one single deposition.

Fig. 4a-d illustrate that a hole 20 etched from the backside may be filled using backside hole-filling. The steps of Fig. 4a-d may be performed in the order indicated by the arrows between the figures.

Fig. 4a illustrates the semiconductor device 1 after forming the stack of FETs 60 and forming the first insulating layer 11. At this point neither the hole 20 nor the trench 30 has been etched.

Fig. 4a further illustrates that a MINT layer 70 may be formed on top of the first insulating layer 11 before etching the hole 20 and before etching the trench 30. For example a MINT line 71 may be arranged on top of the first insulating layer 11 such that the via 21, when formed, connects to said MINT line 71.

Fig. 4b illustrates the semiconductor device 1 after a trench 30 being etched, from the bottom side 4b of the substrate 4 towards the first insulating layer 11, such that the top part 30p of the trench 30 comprises the bottom side 51b of the first source/drain region 51.

Fig. 4c illustrates the semiconductor device 1 after etching the hole 20 from the bottom side 4b of the substrate 4. The hole 20 may herein be etched from a top end of the trench to the top side 11t of the first insulating layer 11, i.e. from the bottom endpoint 25 to the top endpoint 26. Thus, the top part 30p of the trench 30 comprises the bottom endpoint 25. A characteristic of a hole 20 etched by backside-etching may be that it tapers upwards, i.e. the width of the hole 20 at the top endpoint 26 may be smaller than the width of the hole 20 at the bottom endpoint 25.

Fig. 4c illustrates the semiconductor device 1 after filling the hole 20 with electrically conductive material and filling the top part 30p of the trench 30 with electrically conductive material. The hole 20 and the top part 30p of the trench 30 may be filled with electrically conductive material simultaneously, e.g. in one single deposition.

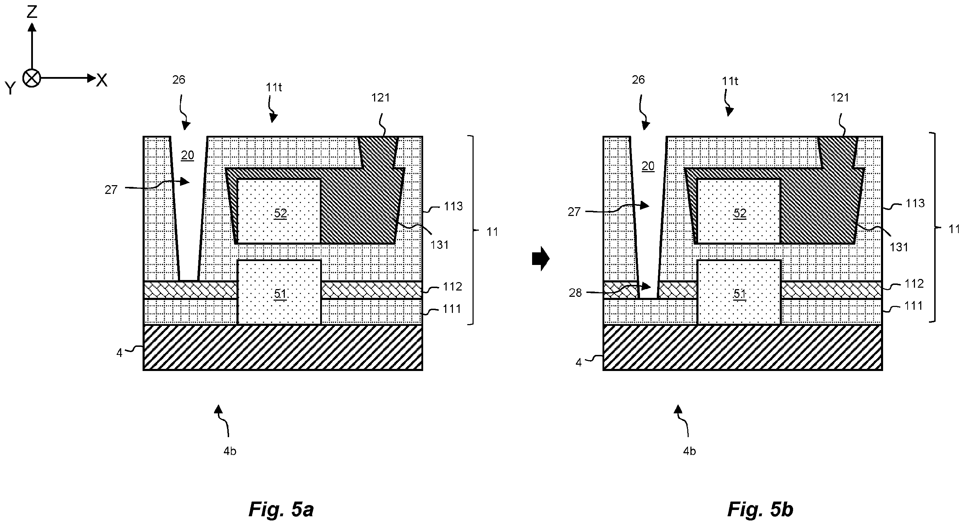

Fig. 5a-b illustrate that parts of a hole 20 may be etched using an etchstop. The steps of Fig. 5a-b may be performed in the order indicated by the arrow between the figures.

In Fig. 5a-b, the first insulating layer 11 comprises a first sublayer 111, a second sublayer 112 stacked on top of the first sublayer 111, and a third sublayer 113 stacked on top of the second sublayer 112, the second sublayer 112 being arranged between the bottom 61 and top 62 FETs, the second 112 and third 113 sublayers comprising different insulating materials. The first sublayer 111 may comprise SiO₂. The second sublayer 112 may act as an etchstop layer. The second sublayer 112 may comprise Si₃N₄. The third sublayer 113 may comprise SiO₂.

Fig. 5a illustrates the semiconductor device 1 after selectively etching a first part 27 of the hole 20 through the third sublayer 113 down to the second sublayer 112. An example of a dry etch that selectively etches a third sublayer 113 of SiO₂ but does not significantly etch a second sublayer 112 of Si₃N₄ is a fluorine based plasma etch. An example of a wet etch that selectively etches a third sublayer 113 of SiO₂ but does not significantly etch a second sublayer 112 of Si₃N₄ is hydrofluoric acid.

Fig. 5b illustrates the semiconductor device 1 after forming a second part 28 of the hole 20 by expanding the first part 27 of the hole 20 through the second sublayer 112. Thus, the second part 28 of the hole 20 may be formed by etching the second sublayer 112. Either a selective or a non-selective etch may be used.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor device (1), the method comprising:
forming a stack of field effect transistors (60), FETs, on top of a substrate (4), the stack of FETs comprising a bottom FET (61) and a top FET (62), the top FET (62) being stacked on top of the bottom FET (61), the bottom FET (61) comprising at least a first source/drain region (51);
forming a first insulating layer (11), the first insulating layer (11) laterally surrounding the stack of FETs (60);
etching a hole (20) into the first insulating layer (11), the hole (20) being laterally spaced apart from the stack of FETs (60), the hole (20) extending between a top endpoint (26) and a bottom endpoint (25), the top endpoint (26) being arranged at a top side (11t) of the first insulating layer (11), the bottom endpoint (25) being arranged at a level below a bottom level (62b) of the top FET (62);
filling the hole (20) with electrically conductive material such that the electrically conductive material of the filled hole (20) forms a via (21);
etching, from a bottom side (4b) of the substrate (4) towards the first insulating layer (11), a trench (30), such that a top part (30p) of the trench (30) comprises both a bottom side (51b) of the first source/drain region (51) and the bottom endpoint (25);
filling the top part (30p) of the trench (30) with electrically conductive material, such that the electrically conductive material of the filled top part (30p) of the trench (30) electrically connects the bottom side (51b) of the first source/drain region (51) to the bottom endpoint (25) of the via (21), whereby the filled top part (30p) of the trench (30) forms an interconnect (31).

2. The method of claim 1, wherein the top part (30p) of the trench (30) comprises also at least part of a lateral side (51a) of the first source/drain region (51), such that the electrically conductive material of the filled top part (30p) of the trench (30) electrically connects also the lateral side (51a) of the first source/drain region (51) to the via (21).

3. The method of claim 1 or 2, wherein a vertical distance between the bottom FET and the top FET is smaller than 50 nm.

4. The method of any one of the preceding claims, the method further comprising
forming a second insulating layer (12) below the electrically conductive material of the filled top part (30p) of the trench (30);
forming a backside power delivery network (13) below the second insulating layer (12) , wherein the second insulating layer (12) electrically insulates the backside power delivery network (13) from the electrically conductive material of the filled top part (30p) of the trench (30).

5. The method of any one of the preceding claims, wherein the electrically conductive material filling the top part (30p) of the trench (30) is a metal.

6. The method of any one of the preceding claims, wherein forming the stack of FETs comprises:
forming source/drain regions of the bottom and top FET by epitaxial growth;
wherein said acts of filling the hole (20) with electrically conductive material and filling the top part (30p) of the trench (30) with electrically conductive material are performed after said act of forming the source/drain regions of the bottom and top FET.

7. The method of any one of the preceding claims, wherein said act of etching the hole (20) comprises etching at least part of the hole (20) from a top side (11t) of the first insulating layer (11).

8. The method of claim 7, wherein the first insulating layer (11) comprises a first sublayer (111), a second sublayer (112) stacked on top of the first sublayer (111), and a third sublayer (113) stacked on top of the second sublayer (112), the second sublayer (112) being arranged between the bottom (61) and top (62) FETs, the second (112) and third (113) sublayers comprising different insulating materials; wherein forming the hole (20) comprises:
selectively etching a first part (27) of the hole (20) through the third sublayer (113) down to the second sublayer (112);
forming a second part (28) of the hole (20) by expanding the first part (27) of the hole (20) through the second sublayer (112).

9. The method of claim 7 or 8, the method further comprising
depositing a sacrificial material (29) in the hole (20) before etching the trench (30);
removing the sacrificial material (29) in the hole (20) after etching the trench (30), by etching, from the bottom side (4b) of the substrate (4), the sacrificial material (29);
wherein said act of filling the hole (20) with electrically conductive material is performed by filling, from the bottom side (4b) of the substrate (4), the hole (20) with electrically conductive material after said act of removing the sacrificial material (29).

10. The method of any one of claims 1-6, wherein said act of etching the hole (20) is performed after said act of etching the trench (30) and comprises:
etching the hole (20) from the bottom side (4b) of the substrate (4);
wherein said act of filling the hole (20) with electrically conductive material is performed from the bottom side (4b) of the substrate (4).

11. A semiconductor device (1) comprising
a stack of field effect transistors (60), FETs, arranged on top of a substrate (4), the stack of FETs comprising a bottom FET (61) and a top FET (62), the top FET (62) being stacked on top of the bottom FET (61), the bottom FET (61) comprising at least a first source/drain region (51);
a first insulating layer (11), the first insulating layer (11) laterally surrounding the stack of FETs (60);
a via (21) comprising a hole (20) filled with electrically conductive material, the hole (20) being laterally spaced apart from the stack of FETs (60), the hole (20) extending between a top endpoint (26) and a bottom endpoint (25), the top endpoint (26) being arranged at a top side (11t) of the first insulating layer (11), the bottom endpoint (25) being arranged at a level below a bottom level of the top FET (62);
an interconnect (31) comprising a top part (30p) of a trench (30) filled with electrically conductive material, the trench (30) extending from a bottom side (4b) of the substrate (4) towards the first insulating layer (11), wherein the top part (30p) of the trench (30) comprises both a bottom side (51b) of the first source/drain region (51) and the bottom endpoint (25) of the via (21), the electrically conductive material of the filled top part (30p) of the trench (30) electrically connecting the bottom side (51b) of the first source/drain region (51) to the bottom endpoint (25) of the via (21).

12. The semiconductor device (1) of claim 11, wherein the top part (30p) of the trench (30) comprises also at least part of a lateral side (51a) of the first source/drain region (51), such that the electrically conductive material of the filled top part (30p) of the trench (30) electrically connects also the lateral side (51a) of the first source/drain region (51) to the via (21).

13. The semiconductor device (1) of claim 11 or 12, wherein a vertical distance between the bottom FET and the top FET is smaller than 50 nm.

14. The semiconductor device (1) of any one of claims 11-13, further comprising:
a second insulating layer (12) below the electrically conductive material of the filled top part (30p) of the trench (30);
a backside power delivery network (13) below the second insulating layer, wherein the second insulating layer (12) electrically insulates the backside power delivery network (13) from the electrically conductive material of the filled top part (30p) of the trench (30).

15. The semiconductor device (1) of any one of claims 11-14, wherein the electrically conductive material filling the top part (30p) of the trench (30) is a metal.
